## Europäisches Patentamt

## European Patent Office

## Office européen des brevets

(11) Veröffentlichungsnummer: **0 116 333**
A2

# (12) EUROPÄISCHE PATENTANMELDUNG

(21) Anmeldenummer: 84100930.1

(22) Anmeldetag: 30.01.84

(51) Int. Cl.³: **H 01 L 23/52**
H 01 L 21/90, H 01 L 27/10

(30) Priorität: 10.02.83 DE 3304651

(43) Veröffentlichungstag der Anmeldung:
22.08.84 Patentblatt 84/34

(84) Benannte Vertragsstaaten:
AT DE FR GB IT SE

(71) Anmelder: SIEMENS AKTIENGESELLSCHAFT
Berlin und München Wittelsbacherplatz 2
D-8000 München 2(DE)

(72) Erfinder: Schwabe, Ulrich, Dr. phil.
Plievierpark 14
D-8000 München 83(DE)

(72) Erfinder: Neppl, Franz, Dr. rer. nat.
St.-Quirin-Platz 6
D-8000 München 90(DE)

(54) Dynamische Halbleiterspeicherzelle mit wahlfreiem Zugriff (DRAM) und Verfahren zu ihrer Herstellung.

(57) Die Erfindung betrifft eine dynamische Halbleiterspeicherzelle mit wahlfreiem Zugriff (DRAM), bei der die Bitleitung (4, 10) und die Speicherkapazitätselektrode (4, 11) aus einem dotierten Silizid eines hochschmelzenden Metalles bestehen und die Länge des Transfergates (12, 13) durch den Abstand des Silizids auf der Bitleitung (4, 10) und dem Silizid der Speicherkapazitätselektrode (4, 11) definiert ist. Die Erfindung betrifft ferner ein Verfahren zu ihrer Herstellung. Infolge des selbstjustierenden S/D- Kontaktes ist eine höhere Packungsdichte und durch die Verwendung des Silizids eine sehr niederohmige Bit-Leitung möglich. Die Gatelänge ist nicht von der Justiergenauigkeit abhängig, da sie durch den Abstand Silizid-bit-Leitung und Silizidelektrode definiert ist.

FIG 3

EP 0 116 333 A2

SIEMENS AKTIENGESELLSCHAFT          Unser Zeichen
Berlin und München                  VPA   83 P 1063 E

Dynamische Halbleiterspeicherzelle mit wahlfreiem Zugriff (DRAM) und Verfahren zu ihrer Herstellung.

Die Erfindung betrifft eine dynamische Halbleiterspeicherzelle mit wahlfreiem Zugriff (DRAM), bei der die Bitleitung im Bereich der Speicherzellen in das Halbleitersubstrat hineindiffundiert ist, benachbart zu der Bitleitung zur Erzeugung der Speicherkapazität über dem Halbleitersubstrat und isoliert zu diesem eine Speicherelektrode angeordnet ist und oberhalb der Bitleitung und der Speicherelektrode isoliert zu diesen und die Speicherkapazitätselektrode mindestens teilweise überlappend die von einer Wortleitung angesteuerte Transferelektrode angeordnet ist, sowie Verfahren zur Herstellung derselben.

Es ist bekannt, Halbleiterspeicher in MOS-Technik aufzubauen. Diese Speicherzellen bestehen zum Beispiel aus einer Speicherkapazität und einem MOS-Transistor, dessen Steuerelektrode mit einer Wortleitung verbunden ist. Die beiden gesteuerten Elektroden des MOS-Transistors liegen zwischen der Speicherkapazität und einer Bitleitung. Solche Speicherzellen werden als Eintransistor-RAM (= random access memory)-Zellen bezeichnet.

Ein Nachteil solcher Eintransistorspeicherzellen besteht darin, daß für die diffundierten Bereiche in dem Speicherbaustein Platz benötigt wird. Da aber bei den Halbleiterspeichern auf einem Speicherbaustein möglichst viele Speicherzellen angeordnet werden sollen, besteht die Tendenz, die Einzelspeicherzelle möglichst klein auszuführen.

Edt 1 Plr/26.1.1983

Eine Möglichkeit dies zu realisieren ist, die Speicherelektrode zur Bildung der Speicherkapazität über dem Halbleitersubstrat, abisoliert von dem Halbleitersubstrat anzuordnen. Benachbart zu der Speicherkapazität wird die Bitleitung in das Halbleitersubstrat hineindiffundiert. Um einen Ladungsaustausch zwischen der Speicherkapazität und der Bitleitung zu ermöglichen, wird auf dem Halbleitersubstrat isoliert zum Halbleitersubstrat die sogenannte Transferelektrode angeordnet, die die Speicherkapazität und die Bitleitung zumindest teilweise überlappt.

Weitere platzsparende Möglichkeiten ergeben sich durch die Verwendung der Doppel-Poly-Silizium-Technologie bei der Herstellung der Speicherzellen. Eine Speicherzelle der eingangs genannten Art mit diffundierter Bitleitung mit "buried-Kontakt" in Zweilagen-Poly-Silizium-Technologie ist aus einem Aufsatz von V. L. Rideout aus dem IEEE Trans. Electron. Dev. Vol. ED-26, Nr. 6 (1979) auf den Seiten 839 bis 852, insbesondere Seite 846, zu entnehmen.

Die Aufgabe, die der Erfindung zugrundeliegt, besteht nun in einer weiteren Erhöhung der Packungsdichte von Speicherzellen für dynamische Halbleiterspeicherzellen mit wahlfreiem Zugriff (DRAM) in einem Speicherbaustein und insbesondere in der Angabe von Verfahren zu ihrer möglichst einfachen Herstellung, wobei gewährleistet ist, daß maskenaufwendige Verfahrensschritte, die eine hohe Genauigkeit bei der Justierung erfordern, unterbleiben können.

Die erfindungsgemäße Aufgabe wird durch eine Speicherzelle der eingangs genannten Art dadurch gelöst, daß die Bitleitung und die Speicherelektrode aus einem dotierten Silizid eines hochschmelzenden Metalles bestehen und die Länge des Transfergates durch den Abstand des Silizids auf der Bitleitung und dem Silizid der Kapazitätselektrode definiert ist.

In einer Weiterbildung des Erfindungsgedankens ist vorgesehen, daß die Bitleitung und die Speicherkapazitätselektrode aus einem, mit Arsen, Phosphor oder Bor dotierten Silizid der Metalle Tantal, Titan, Wolfram oder Molybdän besteht, wobei mehr Silizium in der Verbindung enthalten ist, als der Stöchiometrie entspricht, und daß die Transferelektrode aus Polysilizium, dem System Polysilizium/hochschmelzendes Metall, dem System Polysilizium/Metallsilizid, aus einem Silizid der Metalle Tantal, Titan, Wolfram oder Molybdän, oder aus reinem Metall besteht.

Zur Herstellung der erfindungsgemäßen Speicherzelle wird ein Verfahren vorgeschlagen, welches dadurch gekennzeichnet ist, daß das unter der Bitleitung liegende Draingebiet durch Ausdiffusion von mit einem Dotierstoff eines zweiten Leitungstyps versehenen, direkt auf der Oberfläche eines, durch dicke Oxidbereiche auf oder in seiner Oberfläche aufgeteilte Halbleitersubstrats vom ersten Leitungstyp abgeschiedenen Silizids eines hochschmelzenden Metalles erzeugt wird. Dabei kann die Dotierung nach der Abscheidung der Silizidschicht durch Implantation von Dotierstoffionen des zweiten Leitungstyps in das Silizid erfolgen; es kann aber auch die Metallsilizidschicht dotiert durch Verwendung eines mit dem Dotierstoff versetzten Tantal-, Titan-, Wolfram- oder Molybdänsilizidtargets durch Zerstäuben oder durch reaktives Zerstäuben von undotiertem Silizid in einer den Dotierstoff enthaltenden Atmosphäre aufgebracht werden. Als Dotierstoff vom zweiten Leitungstyp wird Arsen, Phosphor oder Bor verwendet.

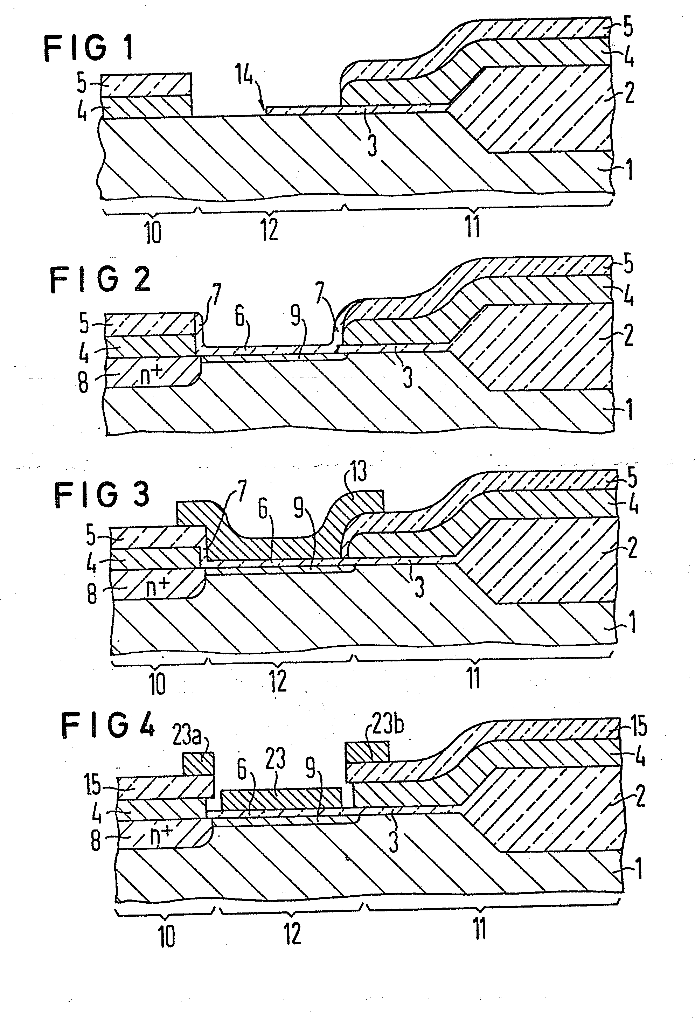

Weitere Einzelheiten des erfindungsgemäßen Verfahrens werden nachfolgend anhand eines Ausführungsbeispiels und der in der Zeichnung befindlichen Figuren 1 bis 4 noch näher erläutert. Dabei zeigen die Figuren 1 bis 3 im Schnittbild und im Ausschnitt die erfindungswesentlichen Verfahrensschritte zur Herstellung einer dynamischen RAM-Zelle mit n-Kanal-Transistoren, wobei das Transfergate sowohl den Rand des unter der Bitleitung liegenden Draingebietes als auch den Rand der Speicherkapazitätselektrode überlappt. Die Figur 4 zeigt eine andere Ausführungsform der Erfindung, bei der die Gateelektrode selbstjustierend aufgebracht ist. Gleiche Bezugszeichen sind für gleiche Teile verwendet worden. Auf die Darstellung der die erfindungswesentlichen Verfahrensschritte nicht betreffenden Details, die Anordnung der Zelle in einer integrierten Schaltung, Passivierung und Durchführung der Metallisierung, ist hier verzichtet worden.

Figur 1: Auf einem p-dotierten Siliziumhalbleitersubstrat 1 werden zur Trennung der aktiven Bereiche strukturierte $SiO_2$-Schichten 2 nach dem sogenannten LOCOS- oder Isoplanarverfahren erzeugt. Dann wird ganzflächig ein Oxidationsprozeß durchgeführt und die entstandene Oxidschicht 3 (40 nm) zur Definition der Speicherkapazitäten und der Bitleitung strukturiert. Im Anschluß daran erfolgt die Abscheidung einer, mit Arsen dotierten Tantalsilizidschicht 4 in einer Schichtdicke von 200 nm, beispielsweise durch Zerstäuben unter Verwendung eines mit Arsen dotierten Tantalsilizid-Targets, wobei, um die spätere Reoxidation zu ermöglichen, mehr Silizium vorhanden ist als der Stöchiometrie von Tantalsilizid entspricht. Auf diese Schicht (4) wird ganzflächig eine aus $SiO_2$ bestehende Isolationsschicht 5 zur Reduzierung der Überlappungskapazitäten und zur Vermeidung von Dotierstoff-Ausdiffusion in einer Schichtdicke von ca. 300 nm aufgebracht und die $SiO_2$-Schicht 5 mit der darunterliegenden Tantalsilizidschicht 4 im Bitleitungsbereich 10 und im Speicherkapazitätsbereich 11 durch ein reaktives Trockenätzverfahren strukturiert. Dabei muß der Abstand der Dünnoxidkante 14 zum Bitleitungsbereich 10 und zur Speicherkapazität 11 mindestens der Justiertoleranz entsprechen (im Ausführungsbeispiel liegt der Abstand im Bereich von 500 bis 1000 nm). Damit ist sichergestellt, daß die Silizid-

0116333

schicht 4, 11 keinen Kontakt zum Si-Substrat hat und die Silizidschicht 4, 10 ganzflächig auf dem Substrat aufliegt.

Figur 2: Es folgt eine ganzflächige Oxidätzung, bei der der Oxidbereich 14 entfernt wird. Bei der thermischen Behandlung zur Erzeugung des Gateoxids 6 bei 900°C wird gleichzeitig das unterhalb der Silizidstruktur 4 im Bitleitungsbereich 10 liegende Draingebiet 8 durch Ausdiffusion von Arsen ($n^+$) erzeugt und die Silizidflanken mit einem Oxid 7 versehen.

Figur 3: Im Anschluß an die Erzeugung der Kanalzone 9 im Transfergatebereich 12 durch Implantation von Bor-Ionen erfolgt die ganzflächige Abscheidung der das Transfergate 12 bildenden Polysiliziumschicht 13, welche so strukturiert wird, daß die Gateelektrode den der Kanalzone 9 zugewandten Rand des Draingebietes 8 und den der Kanalzone 9 zugewandten Rand der Speicherkapazitätselektrode 11 überlappt.

Abschließend wird, wie nicht mehr dargestellt ist, eine als Isolationsoxid dienende Zwischenschicht erzeugt, die Kontaktlöcher für die Leiterbahnen geätzt und die Metallisierung durchgeführt.

Figur 4 zeigt eine andere vorteilhafte Ausführungsform der Erfindung, in der zum Unterschied zu Figur 3 zur Erzeugung minimaler Überlappungskapazitäten das Transfergate (12) nicht überlappend ausgebildet ist, sondern unter Verwendung der sogenannten Abhebetechnik selbstjustierend zwischen die Silizidstrukturen 4 eingebracht wird. Dies geschieht auf folgende Weise: anstelle der aus $SiO_2$ bestehenden Isolationsschicht 5 (nach Figur 1) wird eine aus Siliziumnitrid bestehende Isolationsschicht 15 aufgebracht und anstelle der das Transfergate bildenden Polysiliziumschicht 13 (nach Figur 3) eine Metallsilizidschicht 23 verwendet. Beim Aufdampfen dieser Metallsilizidschicht 23 reißt zwangsläufig die Verbindung an den Siliziumnitridkanten im Transfergatebereich 12 ab. Die Figur 4 zeigt die Anordnung nach der Strukturierung der Gateelektrode. Die auf der Nitridschicht 15 befindlichen Teilstrukturen 23a und 23b werden bei der Entfernung der Nitridschicht 15 unter Verwendung eines isotropen Ätzverfahrens durch Abheben entfernt. Dann wird, wie nicht mehr dargestellt ist, das Isolationsoxid erzeugt, die Kontaktlöcher für die Leiterbahnen geätzt und die Metallisierung durchgeführt.

Diese Prozesse sind analog auch mit p-Kanal-Transistoren möglich, wie es beispielsweise in dem Aufsatz von Shimohigashi im IEEE Trans. Electron. Dev. Vol. ED-29, Nr. 4 (1982) Seiten 714 bis 718, beschrieben ist.

Durch die erfindungsgemäße Speicherzelle mit der sogenannten Silizid-Feldplatte (4, 11 "fieldplate"), der Bit-Leitung aus dem Silizid (4, 10) und dem aus dem Silizid diffundierten $n^+$-Gebiet 8 werden gegenüber der bekannten Anordnung (zum Beispiel Rideout) folgende Vorteile erzielt:

1. Das Silizid wirkt als selbstjustierender Kontakt für den Transfer-Transistor. Infolge des selbstjustierenden Kontaktes ist eine höhere Packungsdichte möglich.

2. Die Gatelänge ist nicht von der Justiergenauigkeit abhängig, da sie durch den Abstand Silizid-Bit-Leitung und Silizid-Feldplatte definiert ist.

3. Durch die Verwendung des Silizids erhält man eine sehr niederohmige Bit-Leitung.

12 Patentansprüche
4 Figuren

Patentansprüche

1. Dynamische Halbleiterspeicherzelle mit wahlfreiem Zugriff (DRAM), bei der die Bitleitung im Bereich der Speicherzelle in das Halbleitersubstrat hineindiffundiert ist, benachbart zu der Bitleitung zur Erzeugung der Speicherkapazität über dem Halbleitersubstrat und isoliert zu diesem eine Speicherelektrode angeordnet ist und oberhalb der Bitleitung und der Speicherelektrode isoliert zu diesen und die Speicherkapazitätselektrode mindestens teilweise überlappend die von einer Wortleitung angesteuerte Transferelektrode angeordnet ist, d a d u r c h   g e -
k e n n z e i c h n e t , daß die Bitleitung (4, 10) und die Speicnerelektrode (4, 11) aus einem dotierten Silizid eines hochschmelzenden Metalles bestehen und die Länge des Transfergates (12) durch den Abstand des Silizids auf der Bitleitung (4, 10) und dem Silizid der Speicherkapazitätselektrode (4, 11) definiert ist.

2. Dynamische Halbleiterspeicherzelle nach Anspruch 1, d a d u r c h   g e k e n n z e i c h n e t , daß die Bitleitung (10) und die Speicherkapazitätselektrode (11) aus einem, mit Arsen, Phosphor oder Bor dotierten Silizid der Metalle Tantal, Titan, Wolfram oder Molybdän besteht, wobei mehr Silizium in der Verbindung enthalten ist, als der Stöchiometrie entspricht.

3. Dynamische Halbleiterspeicherzelle nach Anspruch 1 und/oder 2, d a d u r c h   g e k e n n z e i c h n e t , daß die Transferelektrode (12) aus Polysilizium, dem System Polysilizium/hochschmelzendes Metall, dem System Polysilizium/Metallsilizid oder aus einem Silizid der Metalle Tantal, Titan, Wolfram oder Molybdän oder aus reinem Metall besteht.

4. Verfahren zur Herstellung von dynamischen Halbleiterspeicherzellen mit wahlfreiem Zugriff (DRAM) nach An-

spruch 1 bis 3, d a d u r c h g e k e n n z e i c h - n e t , daß das unter der Bitleitung (10) liegende Draingebiet (8) durch Ausdiffusion von mit einem Dotierstoff eines zweiten Leitungstyps versehenen, direkt auf der Oberfläche eines, durch dicke Oxidbereiche (2) auf oder in seiner Oberfläche aufgeteilten Halbleitersubstrats (1) vom ersten Leitungstyp abgeschiedenen Silizid (4) eines hochschmelzenden Metalles erzeugt wird.

5. Verfahren nach Anspruch 4, d a d u r c h g e - k e n n z e i c h n e t , daß die Dotierung nach Abscheidung der Silizidschicht (4) durch Implantation von Dotierstoffionen des zweiten Leitungstyps erfolgt.

6. Verfahren nach Anspruch 4, d a d u r c h g e - k e n n z e i c h n e t , daß die Metallsilizid- schicht (4) unter Verwendung eines, mit dem Dotierstoff versetzten Tantal-, Titan-, Wolfram- oder Molybdän- Silizidtargets durch Zerstäuben erfolgt.

7. Verfahren nach Anspruch 4, d a d u r c h g e - k e n n z e i c h n e t , daß die Metallsilizidschicht (4) durch reaktives Zerstäuben von undotiertem Silizid in einer den Dotierstoff enthaltenden Atmosphäre aufgebracht wird.

8. Verfahren nach einem der Ansprüche 4 bis 7, d a - d u r c h g e k e n n z e i c h n e t , daß als Do- tierstoff vom zweiten Leitungstyp Arsen, Phosphor oder Bor verwendet wird.

9. Verfahren zum Herstellen von dynamischen Halbleiterspeicherzellen mit wahlfreiem Zugriff (DRAM) nach einem der Verfahrensschritte 1 bis 8, g e k e n n - z e i c h n e t d u r c h den Ablauf der folgen- den Verfahrensschritte:

a) Herstellen von strukturierten SiO$_2$-Schichten (2) auf einem Siliziumhalbleitersubstrat (1) eines ersten Leitungstyps zur Trennung der aktiven Bereiche nach dem sogenannten LOCOS- oder Isoplanarverfahren,

b) Durchführung eines Oxidationsprozesses zur Erzeugung des Speicherkapazitätsoxids (3),

c) Strukturierung des Speicherkapazitätsoxids (3) auf dem Siliziumhalbleitersubstrat (1) zur Definition der Speicherkapazitäten,

d) Abscheidung einer ganzflächigen, mit dem Dotierstoff des zweiten Leitungstyps versehenen, aus einem Silizid der Metalle Tantal, Titan, Wolfram oder Molybdän mit Siliziumüberschuß bestehenden Schicht (4) durch Aufdampfen, Zerstäuben unter Verwendung eines mit dem Dotierstoff versetzten Targets oder reaktives Aufstäuben in einer den Dotierstoff enthaltenden Atmosphäre,

e) ganzflächige Abscheidung einer aus SiO$_2$ oder Siliziumnitrid bestehenden Isolationsschicht (5),

f) Strukturierung der mit der SiO$_2$-Schicht (5) versehenen Metallsilizidschicht (4) im Bitleitungs (10)- und Speicherkapazitätsbereich (11) durch einen reaktiven Trockenätzprozeß,

g) ganzflächige Oxidätzung zur Entfernung des Oxidbereiches (14),

h) Durchführung einer thermischen Behandlung zur Erzeugung des Gateoxids (6), des Oxids auf den Silizidflanken (7) und des unter der als Bitleitung (10) dienenden Metallsilizidschicht (4) liegenden Draingebietes (8) durch Ausdiffusion des in der Metallsilizidschicht (4) enthaltenen Dotierstoffes vom zweiten
Leitungstyp,

i) Erzeugung einer Kanalzone (9) im Gatebereich (12)
durch Implantation von Dotierstoffen eines ersten
Leitungstyps,

j) ganzflächige Abscheidung einer, das Transfergate (12)
bildenden Polysiliziumschicht (13),

k) Strukturierung der Polysiliziumschicht (13) so, daß
die entstandene Gateelektrode den der Kanalzone (9)
zugewandten Rand des Draingebietes (8) und den der
Kanalzone (9) zugewandten Rand der Speicherelektrode
(11) überlappt,

l) Erzeugen einer als Isolationsoxid dienenden Zwischenschicht, Ätzen der Kontaktlöcher in die Zwischenschicht und Durchführung der Metallisierung in bekannter Weise.

10. Verfahren nach Anspruch 9, d a d u r c h   g e -
k e n n z e i c h n e t , daß gemäß Verfahrensschritt e)
Siliziumnitrid als Isolationsschicht (15) verwendet wird,
daß anstelle des Verfahrensschrittes j) eine das Transfergate (12) bildende Metallsilizid- oder Metallschicht (23)
ganzflächig aufgedampft wird, wobei an der Nitridschichtkante die Verbindung der Metallsilizid- oder Metallschicht (23) unterbrochen wird, und daß nach der Strukturierung der Gateelektrode gemäß Verfahrensschritt k)
durch isotropes Ätzen die Siliziumnitridschicht (15)
entfernt wird, wobei die darauf befindlichen Metallsilizid- oder Metallschicht-Strukturen (23a, 23b) mit abgehoben werden.

11. Verfahren nach einem der Ansprüche 8 bis 10, d a -
d u r c h   g e k e n n z e i c h n e t , daß die Dicke

0116333

83 P 1063 E

derSpeicheroxidschicht (3) auf 20 - 50 nm eingestellt
wird.

12. Verfahren nach einem der Ansprüche 9 bis 11, d a -
d u r c h  g e k e n n z e i c h n e t , daß die Dicke
der Isolationsschicht nach Verfahrensschritt e) auf einen
Bereich von 100 bis 500 nm eingestellt wird.

1/1

FIG 1

FIG 2

FIG 3

FIG 4